# EUROPÄISCHE PATENTSCHRIFT

(11) **EP 3 218 303 B1**
(45) Veröffentlichungstag und Bekanntmachung des Hinweises auf die Patenterteilung: **07.07.2021**
(21) Anmeldenummer: 15791629.7
(22) Anmeldetag: 10.11.2015
(51) Int. Cl.: B81C 1/00, H04R 19/00, H04R 19/04

(54) **MEMS PACKAGE**
MICROELECTROMECHANICAL SYSTEM (MEMS) PACKAGE
BOÎTIER DE SYSTÈME MICROÉLECTROMÉCANIQUE

(30) Priorität: 10.11.2014 EP 14290341
(43) Veröffentlichungstag der Anmeldung: 20.09.2017
(73) Patentinhaber: AT & S Austria Technologie & Systemtechnik Aktiengesellschaft, 8700 Leoben (AT)
(72) Erfinder: LEITGEB, Markus, 8793 Trofaiach (AT); RENAUD-BEZOT, Nick, 8700 Leoben (AT)
(74) Vertreter: Dilg, Haeusler, Schindelmann Patentanwaltsgesellschaft mbH
(86) Internationale Anmeldenummer: PCT/EP2015/076158
(87) Internationale Veröffentlichungsnummer: WO 2016/075113

(56) Entgegenhaltungen:
- US-A1- 2012 087 521
- US-A1- 2012 153 771
- US-A1- 2013 193 533
- US-B1- 8 115 283

## Beschreibung

Die Erfindung betrifft ein Package, eine Anordnung und ein Verfahren zum Herstellen einer elektronischen Vorrichtung.

MEMS-Komponenten (microelectromechanical systems, mikroelektromechanische Systeme) wurden zunächst mit herkömmlichen Halbleitertools hergestellt. Spezifische Erfordernisse, hinsichtlich zum Beispiel Dimensionen, Materialien, Formen, etc., führten zu der Entwicklung von speziellen Prozessen. Diese Weiterentwicklung gegenüber den Ursprüngen führte dazu, dass die Steuer-ICs nicht auf denselben Substraten hergestellt wurden wie die MEMS-Komponente selbst. Selbst obwohl CMOS-kompatible Prozesse eingeführt worden sind (was Einzelchip-MEMS/ICs ermöglichte), trennt die große Mehrzahl von MEMS-Anwendungen den Sensor/Aktuator von der Steuerung. Mit dem fortschreitenden Trend nach kleineren Formfaktoren und verbesserter Leistungsfähigkeit bei niedrigeren Kosten besteht Raum für Weiterentwicklungen im Hinblick auf heterogene Integration.

Patentschrifft US 2012/0087521 A1 offenbart ein MEMS Sensor mit elektronischen Baustein Package mit einem Durchgangsloch sowohl in dem Leiterplatte-Substrat als auch in einer metallischen Abdeckstruktur und einen elektronischen Baustein der in dem Substrate eingebettet ist.

Patentschrifft US 8115283 B1 offenbart ein MEMS Package mit einer Leiterplatte als Abdeckstruktur jedoch mit kein Durchgangsloch in dieser Abdeckstruktur und wo der elektronischen Baustein nicht in der Basisstruktur eingebettet ist.

Es ist eine Aufgabe der vorliegenden Erfindung, ein effizient herstellbares Package bereitzustellen.

Diese Aufgabe wird durch die Gegenstände mit den Merkmalen gemäß den unabhängigen Patentansprüchen gelöst. Weitere Ausführungsbeispiele sind in den abhängigen Ansprüchen gezeigt.

Anspruch 1 beschreibt ein Package gemäß der Erfindung. Ein Verfahren zum Herstellen von Packages und ein Anordnung von Packages sind in die Ansprüche 11 und 15 definiert.

Im Kontext der vorliegenden Anmeldung wird unter dem Begriff "elektronischer Baustein" insbesondere jede aktive elektronische Komponente (wie zum Beispiel ein elektronischer Chip, insbesondere ein Halbleiterchip) oder jede beliebige passive elektronische Komponente (wie zum Beispiel ein Kondensator) verstanden. Beispiele der eingebetteten Bausteine bzw. Komponenten sind ein Datenspeicher wie zum Beispiel ein DRAM (oder jeder andere beliebige Speicher), ein Filter (der zum Beispiel als ein Hochpassfilter, ein Tiefpassfilter oder ein Bandpassfilter konfiguriert sein kann, und der zum Beispiel zum Frequenzfiltern dienen kann), ein integrierter Schaltkreis (wie zum Beispiel ein Logik IC), eine Signalverarbeitungskomponente (wie zum Beispiel ein Mikroprozessor), eine Leistungsmanagementkomponente, ein optischelektrisches Schnittstellenelement (zum Beispiel ein optoelektronisches Bauelement), ein Spannungswandler (wie zum Beispiel ein DC/DC Konverter oder ein AC/DC Konverter), eine kryptografische Komponente, eine Kapazität, eine Induktivität, ein Schalter (zum Beispiel ein Transistor-basierter Schalter) und eine Kombination von diesen und anderen funktionalen elektronischen Bauteilen.

Durch das Vorsehen der Basisstruktur aus einem dielektrischen Material mit daran und/oder darin gebildeten elektrisch leitfähigen Kontaktierungsstrukturen ist es möglich, der Unterlage des mindestens einen elektronischen Bausteins und der mindestens einen MEMS Komponente simultan eine mechanische Befestigungsfunktion und eine elektrische Kontaktierungsfunktion zu verleihen. Insbesondere ist eine derartige Architektur kompatibel mit der Verwendung eines PCB-Substrats oder eines Teils davon als Basisstruktur, was eine kostengünstige Fertigung und den Rückgriff auf wohldefinierte PCB Prozesse ermöglicht und somit die PCB Technologie für die MEMS-Technologie erschließt. Alternativ können aber auch vollständig elektrisch leitfähige Basisstrukturen, wie zum Beispiel ein Leadframe, verwendet werden. Durch ein Einbetten oder Integrieren des mindestens einen elektronischen Bausteins in die Basisstruktur kann eine niedrige Bauhöhe des Package erreicht werden, selbst wenn der elektronische Baustein und die MEMS-Komponente übereinander angeordnet werden. Alternativ sind aber auch nicht-eingebettete Architekturen möglich. Indem eine vertikale Anordnung von elektronischem Baustein und MEMS-Komponente durch das Vergraben des elektronischen Bausteins in der Basisstruktur ermöglicht wird, ist auch eine niedrige laterale Ausdehnung des Packages erreichbar. Ferner kann durch das elektrisch isolierende Material der Basisstruktur eine dielektrische Montagebasis bereitgestellt und durch das Vorsehen einer elektrisch leitfähigen Kontaktstruktur in und/oder auf diesem elektrisch leitfähigen Material eine Kontaktierung zwischen dem vergrabenen elektronischen Baustein und der MEMS-Komponente bewerkstelligt werden. Auch ist eine solche Anordnung flexibel hinsichtlich der Verwendung einer Abdeckstruktur, die in ganz unterschiedlichen Konfigurationen ausgebildet sein kann und die MEMS-Komponente gegenüber der Umgebung abschirmt. Gleichzeitig kann das Package durch eine Montage der Abdeckstruktur an der Basisstruktur nach außen hin mechanisch geschützt werden und abgeschlossen werden. Insgesamt ist ein kompaktes und einfach herstellbares Package bereitgestellt, das insbesondere auch in einer batchartigen Architektur herstellbar ist. Hierfür können mehrere elektronische Bausteine in einer Basismasterstruktur eingebettet oder darauf aufgesetzt werden und können entsprechend mehrere MEMS-Komponenten auf der Basismasterstruktur montiert werden. Nach Bedecken der so erhaltenen Anordnung durch eine Abdeckmasterstruktur wird eine Vorform für eine Vielzahl von Packages erhalten. Durch bloßes Singularisieren dieser Anordnung kann eine Vielzahl von Packages gewonnen werden. Zusätzlich zu dem erreichbaren kleineren Footprint hat das Einbetten des zumindest einen elektronischen Bausteins die weiteren Vorteile einer besseren elektronischen Leistungsfähigkeit und eines niedrigeren Energiebedarfs als Folge von kürzeren leitfähigen Pfaden zwischen dem zumindest einen elektronischen Baustein und der zumindest einen MEMS-Komponente.

Im Weiteren werden zusätzliche exemplarische Ausführungsbeispiele des Package, der Anordnung und des Verfahrens beschrieben.

Gemäß einem exemplarischen Ausführungsbeispiel kann die MEMS-Komponente an der Basisstruktur montiert sein. Alternativ oder ergänzend kann die MEMS-Komponente an der Abdeckstruktur montiert sein. Die MEMS-Komponente kann auch zumindest teilweise in der Basisstruktur und/oder in der Abdeckstruktur eingebettet sein.

In entsprechender Weise können die MEMS-Komponenten an der Basismasterstruktur montiert sein. Alternativ oder ergänzend können die MEMS-Komponenten an der Abdeckmasterstruktur montiert sein. Die MEMS-Komponenten können auch zumindest teilweise in der Basismasterstruktur und/oder in der Abdeckmasterstruktur eingebettet sein.

Gemäß einem exemplarischen Ausführungsbeispiel kann die Basisstruktur als Leiterplatte konfiguriert sein, insbesondere als gedruckte Leiterplatte, oder als Sektion oder als ein Abschnitt von einer solchen Leiterplatte. Durch Vorsehen der Basisplatte als Leiterplatte, insbesondere als gedruckte Leiterplatte (printed circuit board, PCB), kann eine Montagebasis für die MEMS-Komponente und den elektronischen Baustein bereitgestellt werden, die kostengünstig fertigbar ist und bei der die ausgereifte PCB-Technologie zur Anwendung gelangen kann. Auch ist durch das Bereitstellen von elektrisch isolierendem Material und einer elektrisch leitfähigen Kontaktstruktur bei Leiterplatten gleichzeitig eine mechanische Montage und eine elektrische Kontaktierung ermöglicht. Es ist allerdings darauf hinzuweisen, dass der Begriff Leiterplatte andere Architekturen umfassen kann, wie zum Beispiel ein Keramiksubstrat oder andere Substrate.

Gemäß einem exemplarischen Ausführungsbeispiel kann die Abdeckstruktur eine Vergussmasse und/oder ein Metalldeckel und/oder weiteres elektrisch isolierendes Material optional kombiniert mit einer weiteren elektrisch leitfähigen Kontaktstruktur (insbesondere eine Leiterplatte, weiter insbesondere eine gedruckte Leiterplatte, oder eine Sektion oder ein Abschnitt von einer solchen Leiterplatte) sein. Gemäß einer ersten Ausgestaltung kann die Abdeckstruktur eine Vergussmasse (zum Beispiel ein mould compound oder eine optisch transparente Vergussmasse) aufweisen, welche die MEMS-Struktur insbesondere unter Freilassung der mechanisch beweglichen Struktur der MEMS-Komponente verkapseln kann. Alternativ kann ein Metalldeckel aufgesetzt werden, der für eine besonders robuste mechanische Abschirmung der MEMS-Komponente sorgt. Auch ist es gemäß einem besonders bevorzugten Ausführungsbeispiel möglich, die Abdeckstruktur (insbesondere im Zusammenhang mit einer als gedruckte Leiterplatte realisierten Basisstruktur) als Leiterplatte (die eine Mehrzahl von miteinander verbundene Schichtstrukturen aus elektrisch leitfähigem Material und elektrisch isolierendem Material aufweisen kann, und insbesondere plattenförmig bzw. flach sein kann) und weiter bevorzugt als gedruckte Leiterplatte (PCB, printed circuit board) auszugestalten. Durch diese Konfiguration ist es möglich, durch zwei plattenartige Komponenten als Basisstruktur und Abdeckstruktur eine in Höhenrichtung kompakte Bauform mit geringen Herstellungskosten und geringem Herstellungsaufwand zu ermöglichen. Gleichzeitig erlaubt diese Architektur eine batchartige Herstellung einer Mehrzahl von Packages. Hohlräume zum Aufnehmen der MEMS-Struktur und/oder des mindestens einen elektronischen Bausteins können in der als gedruckte Leiterplatte ausgebildeten Abdeckstruktur zum Beispiel mittels mechanischer Abrasion (zum Beispiel Bohren), Abtrag oder Schneiden (zum Beispiel mittels eines Lasers), oder chemisch (zum Beispiel mittels Ätzens) geschaffen werden.

Gemäß einem exemplarischen Ausführungsbeispiel kann das elektrisch isolierende Material aus einer Gruppe ausgewählt sein, die besteht aus Harz (insbesondere aus Bismaleimid-Triazin Harz), Glasfasern, Prepreg-Material, Polyimid, einem Flüssigkristallpolymer, Epoxid-basierte Build-Up Films und FR4 Material. Harzmaterial kann als mechanisch stabile Matrix dienen, die gleichzeitig der jeweiligen Struktur elektrisch isolierende Eigenschaften verleiht. Das Vorsehen von Glasfasern stärkt das elektrisch isolierende Material mechanisch und kann außerdem eine gewünschte räumliche Anisotropie der mechanischen Eigenschaften bewirken. Prepreg-Material ist eine Vorform von FR4-Material und weist eine Mischung von Harz und Glasfasern auf. Durch die Verwendung entsprechender Prepreg-Folien mit Ausnehmungen kann die Grundlage dafür geschaffen werden, dass die elektronischen Bausteine in den Öffnungen aufgenommen werden (oder direkt im Material verpresst werden) und nach Verpressen der so erhaltenen Struktur mit weiteren Prepreg-Folien die elektronischen Bausteine in dem elektrisch isolierenden Material vollumfänglich eingebettet werden. FR4 (flame resistant) bezeichnet ein gängiges Material für Leiterplatten, das für ein erfindungsgemäßes MEMS-Package eine hohe mechanische Robustheit bei niedrigen Kosten ermöglicht.

Gemäß einem exemplarischen Ausführungsbeispiel kann der elektronische Baustein zum funktionellen Zusammenwirken mit, insbesondere zum Steuern der MEMS-Komponente konfiguriert sein. Zu diesem Zweck können der elektronische Baustein und die MEMS-Komponente miteinander elektrisch gekoppelt sein, was mittels der elektrisch leitfähigen Kontaktierung erfolgen kann. Dann können elektrische Signale zwischen dem elektronischen Baustein und der MEMS-Komponente kommuniziert werden. Gemäß einer Ausgestaltung kann der elektronische Baustein elektronische Steuersignale an die MEMS-Komponente übermitteln, basierend auf welchen diese eine Funktion (insbesondere eine Aktuatorfunktion) bereitstellt. Umgekehrt kann die MEMS-Komponente auch ein elektrisches Signal (zum Beispiel ein Sensorsignal, wenn die MEMS-Komponente als Sensor ausgebildet ist) erzeugen und dem elektronischen Baustein zur Weiterverarbeitung bereitstellen.

Gemäß einem exemplarischen Ausführungsbeispiel kann die MEMS-Komponente konfiguriert sein als eine aus der Gruppe bestehend aus einem Sensor und einem Aktuator.

Gemäß einer ersten Ausgestaltung kann die MEMS-Komponente also ein Aktuator sein. Unter einem Aktuator kann eine MEMS-Komponente verstanden werden, die in Reaktion auf ein Stimulussignal eine mechanische Bewegung durchführt. Zum Beispiel kann ein solcher Aktuator ein Lautsprecher (insbesondere ein Balanced-Armature Empfänger) sein, der bei Anlegen eines elektrischen Signals eine piezoelektrische Membran zu Schwingungen und zum Emittieren von akustischen Wellen anregen kann. Andere Beispiele für Aktuatoren als MEMS-Komponenten sind eine Mikropumpe oder ein haptischer Aktuator, der bei Anlegen eines elektrischen Signals eine haptische Rückmeldung erlaubt, zum Beispiel um eine Benutzereingabe in ein elektronisches Gerät zu bestätigen. Ein MEMS-Aktuator kann zum Beispiel auch ein Scanner, eine Autofokuskomponente, eine anpassbare Linse oder ein anpassbarer wellenlängenselektiver Filter sein. Ein anpassbarer wellenlängenselektiver Filter ist eine MEMS-Komponente, die, bei Anlegen einer elektrischen Spannung, in charakteristischer Weise ihre Kapazität verändert, um dadurch speziell für eine bestimmte Wellenlänge von elektromagnetischer Strahlung wie zum Beispiel Licht durchlässig oder reflektierend zu sein.

Alternativ kann die MEMS-Komponente als Sensor ausgebildet sein, die basierend auf einer Eigenschaft der Umgebung ein hierfür charakteristisches Sensorsignal ausgibt. Ein Beispiel hierfür ist ein Mikrofon, das in Reaktion auf in der Umgebung vorhandene Schallwellen oder akustische Wellen ein elektrisches Signal erzeugt, beispielsweise mittels einer piezoelektrischen Membran. Andere Beispiele für MEMS-Sensoren sind ein Drucksensor oder ein Fluidsensor (wobei ein Fluid ein Gas und/oder eine Flüssigkeit aufweisen kann oder daraus bestehen kann) sein.

Gemäß einem exemplarischen Ausführungsbeispiel kann der elektronische Baustein ein Halbleiterchip sein, insbesondere ein anwendungsspezifischer integrierter Schaltkreischip (ASIC). Durch das Ausbilden des mindestens einen elektronischen Bausteins des Packages als Halbleiterchip können die Vorteile der integrierten Schaltkreistechnologie eingesetzt werden, insbesondere das Bereitstellen elektronischer Funktionen in miniaturisierter Weise. Es ist auch möglich, mit einem ASIC einen elektronischen Chip so zu programmieren, dass eine benutzerdefinierte elektronische Funktion gewährleistet wird. Gemäß einem Ausführungsbeispiel kann auch eine Mehrzahl von elektronischen Bausteinen in einem einzigen Package vorgesehen sein, wobei die elektronischen Bausteine auf und/oder in der Basisstruktur vorgesehen sein können.

Allerdings kann der zumindest eine elektronische Baustein auch auf eine andere Weise als als Steuerchip ausgebildet sein, zum Beispiel als CCD (charge coupled device). In diesem Ausführungsbeispiel detektiert der elektronische Baustein elektromagnetische Strahlung, insbesondere erfasst er Bilddaten. In solch einem Ausführungsbeispiel kann der elektronische Baustein des CCD Typs beispielsweise in der Basisstruktur eingebettet sein (wobei eine obere Fläche des CCD Bausteins gegenüber der Basisstruktur freigelegt sein soll, um für elektromagnetische Strahlung empfänglich zu sein) und funktional mit einer einstellbaren Linse eines MEMS-Typs zusammenwirken, die oberhalb des elektronischen Bausteins des CCD Typs angeordnet sein kann, um so als anpassbares optisches Element zum Beeinflussen der mittels der CCD detektierten elektromagnetischen Strahlung zu dienen.

Gemäß einem exemplarischen Ausführungsbeispiel kann zumindest ein Teil von seitlichen Oberflächen des elektronischen Bausteins mit Material der Basisstruktur bedeckt sein. Gemäß dieser Ausgestaltung können die Seitenflächen des mindestens einen elektronischen Bausteins ganz oder teilweise von elektrisch isolierendem Material und/oder von elektrisch leitfähigem Material der Basisstruktur bedeckt sein. Der elektronische Baustein kann entweder vollständig in der Basisstruktur integriert sein oder kann an der Oberseite und/oder an der Unterseite über der Basisstruktur hervorstehen. Durch ein solches Integrieren kann eine kompakte Bauform des Packages erreicht werden.

Gemäß einem exemplarischen Ausführungsbeispiel kann zumindest eine aus der Gruppe bestehend aus der Basisstruktur und der Abdeckstruktur zumindest ein Durchgangsloch zum Bereitstellen einer Fluidverbindung (insbesondere einer Luftverbindung oder einer Flüssigkeitsverbindung) zwischen der MEMS-Komponente und einer Umgebung des Package aufweisen. Durch das Vorsehen eines oder mehrerer Durchgangslöcher ist eine (insbesondere sensorische und/oder aktuatorische) Wirkverbindung der MEMS-Komponente mit der Umgebung ermöglicht. Zum Beispiel kann bei einer Ausgestaltung der MEMS-Komponente als Lautsprecher bzw. Mikrofon durch das Durchgangsloch hindurch eine akustische Verbindung zu der Umgebung bereitgestellt werden, insbesondere um Schallwellen von der MEMS-Komponente in die Umgebung auszugeben oder Schallwellen aus der Umgebung mittels der MEMS-Komponente zu detektieren. Bei Realisierung der MEMS-Komponente als Sensor kann aber auch eine andere Umgebungseigenschaft (zum Beispiel das Vorhandensein von Fluid, eines bestimmten Drucks etc.) durch das Durchgangsloch auf die Sensorkomponente hin übertragen werden.

Gemäß einem exemplarischen Ausführungsbeispiel kann zumindest eine aus der Gruppe bestehend aus der Basisstruktur und der Abdeckstruktur eine Akustikwellenbeeinflussungs-Oberflächenstrukturierung aufweisen, insbesondere gefast sein. Das Fasen oder sonstige Oberflächenstrukturieren von Basisstruktur und/oder Abdeckstruktur, insbesondere im Bereich einer Durchgangsöffnung, erlaubt es, insbesondere die akustischen Eigenschaften in diesem Bereich einzustellen, zum Beispiel zum Filtern bestimmter Frequenzen, Unterdrücken von Rauschen, Definieren von Propagationspfaden von Schallwellen, etc. Auch ein Führen von Schallwellen etc. entlang derartiger Oberflächennuten oder Abflachungen ist somit möglich. Durch ein Fasen um ein Durchgangsloch herum können scharfe Kanten an dem Durchgangsloch geglättet werden und einen trichterförmigen Zugang für akustische Wellen schaffen, wodurch die akustischen Eigenschaften des Packages gefördert werden.

Gemäß einem exemplarischen Ausführungsbeispiel kann die MEMS-Komponente in einer Kavität lokalisiert sein, insbesondere in einer quaderförmigen oder halbkugelförmigen Kavität, die zwischen der Basisstruktur und der Abdeckstruktur begrenzt sein. Indem die MEMS-Komponente in einer Kavität untergebracht ist, in der sie zumindest entlang eines Teils ihrer Oberfläche in direkter Luftverbindung zur Umgebung steht, kann die MEMS-Komponente ihre eine mechanische Bewegung umfassende Funktion erfüllen. Durch ein kappenartiges Vorsehen der Abdeckstruktur kann eine solche Kavität kostengünstig ausgebildet werden.

Gemäß einem exemplarischen Ausführungsbeispiel kann die Abdeckstruktur ein Akustikeigenschaftseinstellmerkmal aufweisen, insbesondere eine Funktionalisierung oder eine Strukturierung zum passiven Filtern von akustischen Wellen. Durch Funktionalisieren (zum Beispiel Oberflächenbeschichten) und/oder Strukturieren (zum Beispiel Ausbilden von Oberflächenvertiefungen wie zum Beispiel Nuten) können die akustischen Eigenschaften des Packages eingestellt werden und unerwünschte Effekte, wie zum Beispiel Rauschen oder das Einkoppeln unerwünschter akustischer Frequenzen, unterdrückt oder gänzlich vermieden werden. Allgemein kann das Akustikeigenschaftseinstellmerkmal eine Anordnung von einer oder mehreren Mikrostrukturen sein, d.h. Mikroüberständen (zum Beispiel Lotkügelchen) und/oder Mikroausnehmungen (wie zum Beispiel Einbuchtungen), die an einer inneren Oberfläche und/oder an einer äußeren Oberfläche der Abdeckstruktur angebracht sein können, um die Eigenschaften beeinflussen zu können, gemäß welchen akustische Wellen in einer Umgebung der Abdeckstruktur propagieren. Es ist auch möglich, an und/oder in der Abdeckstruktur Lötpads und/oder ESD (electrostatic discharge, elektrostatische Entladung)-Schutzeinrichtungen und/oder EMI (electromagnetic interference, elektromagnetische Störung)-Schutzeinrichtungen vorzusehen.

Gemäß einem exemplarischen Ausführungsbeispiel kann das Package Bondmaterial bzw. Verbindungsmaterial an einer Montagestelle zwischen der Basisstruktur und der Abdeckstruktur aufweisen. Ein solches Bondmaterial kann zum Beispiel Klebstoff sein, mit dem die Abdeckstruktur an der Basisstruktur mechanisch befestigt werden kann. Ein solches Bondmaterial kann zum Beispiel Lot oder leitfähige Paste sein, mit dem bzw. der die Abdeckstruktur mit der Basisstruktur auch elektrisch gekoppelt werden kann. Mit einfachen Mitteln kann dadurch auch eine batchweise Ausbildung von Packages erleichtert werden.

Gemäß einem exemplarischen Ausführungsbeispiel kann zumindest ein Teil der elektrisch leitfähigen Kontaktstruktur zum elektrischen Koppeln des elektronischen Bausteins mit der MEMS-Komponente konfiguriert sein. Die elektrisch leitfähige Kontaktstruktur der Basisstruktur (und/oder optional eine entsprechende elektrisch leitfähige Kontaktstruktur der Abdeckstruktur) kann somit unmittelbar oder mittelbar (zum Beispiel unter Zwischenschaltung eines Bonddrahts) zum elektrischen Kontaktieren von elektronischem Baustein und MEMS-Komponente verwendet werden. Dadurch kann die Basisstruktur bzw. Abdeckstruktur nicht nur zum mechanischen Befestigen und Abschirmen von elektronischem Baustein und MEMS-Komponente dienen, sondern simultan auch zum elektrischen Kontaktieren. Gemäß einer Ausgestaltung steuert der elektronische Chip die MEMS-Komponente dahingehend, dass von dem elektronischen Chip an die MEMS-Komponente elektrische Steuersignale übermittelt werden, welche die Funktion der MEMS-Komponente beeinflussen. Beispielsweise kann an eine als Lautsprecher implementierte MEMS-Komponente ein entsprechendes elektrisches Signal angelegt werden, das dann von der MEMS-Komponente in entsprechende Schallwellen umgewandelt wird. Gemäß einer anderen Ausgestaltung kann der elektronische Baustein elektrische Signale, die von der MEMS-Komponente generiert werden, (vor-)verarbeiten und dadurch zum Beispiel eine Sensorausgabe generieren. Die Verbindung zwischen der Basisstruktur und der Abdeckstruktur kann zum Beispiel mittels Lötens oder mechanischen Zusammenpressens ausgebildet werden, bevorzugt unter Verwendung von Bondmaterial dazwischen.

In einem besonders bevorzugten Ausführungsbeispiel ist das Bondmaterial konfiguriert, sowohl eine mechanische Verbindung als auch eine elektrische Kopplung zwischen der Basisstruktur und der Abdeckstruktur zu bewerkstelligen. In solch einem Ausführungsbeispiel kann das Bondmaterial selbst elektrisch leitfähig sein und eine schmale Lücke zwischen einer elektrisch leitfähigen Kontaktstruktur der Basisstruktur und einer elektrisch leitfähigen Kontaktstruktur der Abdeckstruktur überbrücken.

Gemäß einem exemplarischen Ausführungsbeispiel kann bei dem Verfahren ferner zumindest ein weiterer elektronischer Baustein in einer Basismasterstruktur eingebettet werden oder der zumindest eine weitere elektronische Baustein auf einer Basismasterstruktur angeordnet werden, wobei die Basisstruktur Teil der Basismasterstruktur bildet, kann zumindest eine weitere MEMS-Komponente an der Basismasterstruktur montiert werden, kann die zumindest eine weitere MEMS-Komponente mit einer Abdeckmasterstruktur zumindest teilweise abgedeckt werden, die an der Basismasterstruktur montiert wird, wobei die Abdeckstruktur Teil der Abdeckmasterstruktur bildet. Gemäß dieser Ausgestaltung kann die gesamte Prozessierung zum Herstellen von mehreren Packages (zum Beispiel gleichzeitig von mindestens 10, insbesondere von mindestens 100 Packages) durch Verwendung von großflächigen Basismasterstrukturen bzw. Abdeckmasterstrukturen erfolgen. Sowohl die Basismasterstruktur als auch die Abdeckmasterstruktur kann zum Beispiel jeweils eine Leiterplatte (insbesondere eine gedruckte Leiterplatte) darstellen. Indem die Einbettung oder Oberflächenmontage von elektronischen Bausteinen und das Montieren von MEMS-Komponenten batchweise erfolgt, die so erhaltene bestückte Basismasterstruktur mit einer einzigen Abdeckmasterstruktur überdeckt wird und erst nachfolgend eine Singularisierung (zum Beispiel durch Sägen, Ätzen oder Laserschneiden) stattfindet, ist eine effiziente Fertigung der Packages möglich. Diese Vorteile werden insbesondere bei Verwendung von gedruckten Leiterplatten als Grundlage für die Basismasterstruktur bzw. die Abdeckmasterstruktur möglich, da dann bloß zwei flächige Komponenten aneinander befestigt werden müssen. Bei Verwendung einer gedruckten Leiterplatte als Basis für die Abdeckmasterstruktur ist ein einfaches mechanisches, zum Beispiel durch Laser, oder chemisches Strukturieren der gedruckten Leiterplatte von einer Bearbeitungsseite her ausreichend, um die Kavitäten zum abstandsbehafteten Aufnehmen der MEMS-Komponenten zu bilden.

Gemäß einem exemplarischen Ausführungsbeispiel kann ferner ein Singularisieren der mittels Bondmaterial aneinander befestigten Anordnung der Basismasterstruktur mit den elektronischen Bausteinen und den montierten MEMS-Komponenten und der Abdeckmasterstruktur erfolgen, um dadurch zumindest zwei (insbesondere eine große Vielzahl) Packages zu erhalten, von denen jede eine Basisstruktur, mindestens einen elektronischen Baustein, mindestens eine MEMS-Komponente und eine Abdeckstruktur aufweist. Indem das Singularisieren bzw. Trennen erst nach der gruppenweisen Verarbeitung von vielen elektronischen Bausteinen und MEMS-Komponenten durchgeführt wird, können die Fertigungskosten reduziert werden.

Gemäß einem exemplarischen Ausführungsbeispiel können die elektronischen Bausteine und die MEMS-Komponenten zweidimensional über die Basismasterstruktur und die Abdeckmasterstruktur hinweg verteilt sein. Insbesondere können die elektronischen Bausteine bzw. MEMS-Komponenten entlang von Reihen und Spalten auf einer plattenförmigen Basismasterstruktur aufgebracht werden. Die Singularisierung kann dann ebenfalls entlang von Zeilen und Spalten hinweg erfolgen.

Im Folgenden werden exemplarische Ausführungsbeispiele der vorliegenden Erfindung mit Verweis auf die folgenden Figuren detailliert beschrieben.
Figur 1 zeigt eine Querschnittsansicht eines Package gemäß einem exemplarischen Ausführungsbeispiel der Erfindung.
Figur 2 zeigt eine Querschnittsansicht eines Package gemäß einem anderen exemplarischen Ausführungsbeispiel der Erfindung.
Figur 3 zeigt eine Querschnittsansicht eines Package gemäß noch einem anderen exemplarischen Ausführungsbeispiel der Erfindung.
Figur 4 zeigt eine andere Ansicht des Package gemäß Figur 3.
Figur 5 zeigt eine Abdeckmasterstruktur gemäß einem exemplarischen Ausführungsbeispiel der Erfindung.
Figur 6 zeigt eine Basismasterstruktur gemäß einem exemplarischen Ausführungsbeispiel der Erfindung.
Figur 7 zeigt eine schematische Ansicht zur Veranschaulichung von einzelnen Prozessen während eines Verfahrens zum Herstellen von Packages gemäß einem exemplarischen Ausführungsbeispiel der Erfindung.
Figur 8 zeigt eine Basismasterstruktur gemäß einem anderen exemplarischen Ausführungsbeispiel der Erfindung.
Figur 9 zeigt eine schematische Ansicht zur Veranschaulichung von einzelnen Prozessen während eines Verfahrens zum Herstellen von Packages gemäß einem anderen exemplarischen Ausführungsbeispiel der Erfindung.
Figur 10 zeigt eine Abdeckmasterstruktur gemäß einem anderen exemplarischen Ausführungsbeispiel der Erfindung.
Figur 11 zeigt eine Querschnittsansicht einer Anordnung gemäß einem exemplarischen Ausführungsbeispiel der Erfindung.
Figur 12 zeigt eine Querschnittsansicht eines Package gemäß einem anderen exemplarischen Ausführungsbeispiel der Erfindung.
Figur 13 und Figur 14 zeigen Querschnittsansichten von Packages gemäß anderen exemplarischen Ausführungsbeispielen der Erfindung.

Gleiche oder ähnliche Komponenten in unterschiedlichen Figuren sind mit gleichen Bezugsziffern versehen.

Bevor bezugnehmend auf die Figuren exemplarische Ausführungsbeispiele der Erfindung beschrieben werden, sollen noch einige allgemeine Aspekte der Erfindung erläutert werden:
Gemäß einem exemplarischen Ausführungsbeispiel wird eine PCB-basierte Packaging-Architektur für MEMS-Komponenten (insbesondere MEMS-Sensoren oder MEMS-Aktuatoren) bereitgestellt.

Gemäß einem exemplarischen Ausführungsbeispiel der Erfindung wird ein oder werden mehrere Halbleiterchips oder andere elektronische Komponenten auf einem Substrat (das auch als Basismasterstruktur bezeichnet wird) in einem Streifenformat angeordnet. Dabei können Mechanismen wie Chipbefestigung (die attach), Flipchipping (das heißt ein rückseitiges Anordnen von elektronischen Chips auf dem Substrat), Wirebonding (das heißt das Vorsehen von Bonddrähten zum Kontaktieren von elektronischen Chips) zur Anwendung bringen, um gewünschte elektrische und mechanische Verbindungen zu bewerkstelligen. Ein zweiter Streifen (der auch als Abdeckmasterstruktur bezeichnet werden kann) aus einer zu den MEMS-Komponenten bzw. elektronischen Chips entsprechend passenden Anordnung von Kavitäten wird passend zu dem ersten Streifen ausgerichtet und an diesem befestigt. Diese Prozedur kann unter Verwendung von Bondmaterial (zum Beispiel Klebstoff, Epoxymaterial, etc.) erfolgen. Das Bondmaterial kann in geeigneter Weise auf dem Substratstreifen (d.h. der Basismasterstruktur) angebracht werden, zum Beispiel mittels Dispergierens, Stempelns, Druckens, etc. Es ist alternativ oder ergänzend möglich, solches Bondmaterial mit den genannten oder anderen Methoden auf der Abdeckmasterstruktur anzubringen. Nachdem beide Streifen oder Masterstrukturen miteinander verbunden worden sind, können die individuellen Packages singularisiert werden.

Um es einer Druckwelle oder Schallwelle zu gestatten, die MEMS-Komponente zu erreichen, kann ein Durchgangsloch oder können mehrere Durchgangslöcher in einer oder beiden Masterstrukturen vorgesehen werden. Diese Architektur kann einen Bodenzugang der Druck- oder Schallwellen ermöglichen, wenn das Durchgangsloch zwischen Lötpads der Basismasterstruktur angeordnet ist, oder kann ein oberseitiger Port sein, wenn das Durchgangsloch an der Abdeckmasterstruktur vorgesehen ist. Vorzugsweise ist das Durchgangsloch nicht fluchtend mit einer Membran der MEMS-Komponente vorgesehen, um eine Beschädigung derselben durch Einwirken einer mechanischen Belastung durch das Durchgangsloch hindurch auszuschließen. Ein Package mit einem oberseitigen Durchgangsloch hat einen kleineren Footprint, wobei ein unterseitiges Durchgangsloch aufgrund seines höheren Rückvolumens eine höhere Sensitivität zeigt. Der Port muss nicht geradlinig sein, sondern kann eine gewünschte und somit auch komplexere Gestalt haben, und kann zum Beispiel durch ein PCB hindurchgeführt sein.

Mindestens einer der Halbleiterchips und/oder mindestens ein passives Bauelement kann auch in einer der Masterstrukturen eingebettet sein, um die Package-Dimensionen zu reduzieren und die elektrische Performance zu verbessern.

Falls eine hermetische Verbindung zwischen der MEMS-Komponente (insbesondere dem Sensorelement derselben) und dem Durchgangsloch hergestellt wird (um einen externen Zugang zu verunmöglichen, der andere Teile des Systems schädigen könnte), kann die Anordnung bzw. das Package mit Fluidsensoren realisiert werden.

Beim Vorsehen von membranbasierten MEMS-Komponenten ist es vorteilhaft, diese soweit wie möglich zu umschließen, um das bewegliche Element mechanisch zu schützen, ohne dadurch aber die Membran von der Luftverbindung abzukoppeln, über die sie ein Sensorsignal wahrnehmen kann. Dies kann zum Beispiel durch ein PCB als Abdeckmasterstruktur oder eine Metallkappe erreicht werden.

Gemäß einem exemplarischen Ausführungsbeispiel kann der Herstellungsaufwand gering gehalten werden, insbesondere wenn zwei PCBs als Masterstrukturen verwendet werden. Es ist dadurch auch möglich, das Risiko einer Fehlausrichtung (was zu einer Reduktion der Ausbeute führt) zu reduzieren und die Produktionsgeschwindigkeit zu erhöhen.

Es ist möglich, die Abdeckmasterstruktur zu funktionalisieren bzw. zu strukturieren, etwa um passives Filtern zu ermöglichen. Dies ist ein zusätzlicher Vorteil zu der vereinfachten Montage und zu niedrigeren NRE (non-recurring engineering) Kosten.

Bei Vorsehen eines Durchgangslochs in einer der Masterstrukturen kann in der jeweils anderen Masterstruktur ebenfalls ein (vorzugsweise kleineres) Durchgangsloch vorgesehen sein, um einen Druckausgleich zu bewerkstelligen.

Eine Kavität um eine MEMS-Komponente herum (zum Beispiel für das Beispiel eines Lautsprechers als MEMS-Komponente) kann idealerweise so nah wie möglich an einer halbkugelförmigen Gestalt sein, um Schallreflexionen zu unterbinden, was die Performance des Packages negativ beeinflussen würde. Eine solche halbkugelförmige Kavität kann zum Beispiel durch Bohren oder Fräsen mit einem sphärischen Bit erreicht werden.

Es ist auch möglich, zusätzlich zu dem elektronischen Chip eine oder mehrere passive Komponenten (zum Beispiel einen ohmschen Widerstand, einen Kondensator oder einen elektrisch leitfähigen und thermisch leitfähigen Block, beispielsweise einen Kupferblock) in der Basisstruktur zu integrieren.

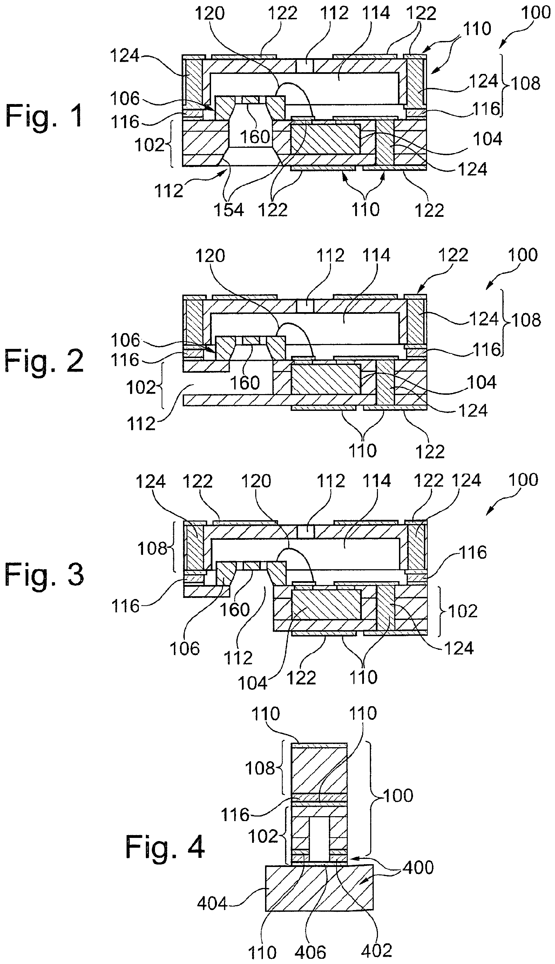

**Figur 1** zeigt eine Querschnittsansicht eines Package 100 gemäß einem exemplarischen Ausführungsbeispiel der Erfindung. Das Package 100 gemäß Figur 1 ist als Lautsprecher konfiguriert.

Das Package 100 weist eine Basisstruktur 102 in Form einer Sektion bzw. eines Abschnitts einer gedruckten Leiterplatte auf, die FR4 als ein elektrisch isolierendes Material und teilweise in und teilweise auf dem elektrisch isolierenden Material vorgesehene Kupferstrukturen als eine elektrisch leitfähige Kontaktstruktur 110 aufweist. Die elektrisch leitfähige Kontaktstruktur 100 weist sowohl strukturierte elektrisch leitfähige Schichten (siehe Bezugszeichen 122) als auch vertikale Durchkontaktierungen, sogenannte Vias, auf (siehe Bezugszeichen 124). Ein als ASIC konfigurierter elektronischer Chip 104 ist in der Basisstruktur 102 eingebettet, könnte alternativ dazu aber auch an der Basisstruktur 102 oberflächenmontiert sein und dient als Steuer IC. Gemäß Figur 1 sind sowohl alle seitlichen Oberflächen als auch die einander gegenüberliegenden oberen und unteren Hauptflächen des elektronischen Chips 104 mit Material der Basisstruktur 102 bedeckt.

Eine mikroelektromechanische System- (microelectromechanical system, MEMS) Komponente 106 ist auf der Basisstruktur 102 oberflächenmontiert und ist mittels der elektrisch leitfähigen Kontaktstruktur 110 sowie mittels eines Bonddrahts 120 mit dem elektronischen Chip 104 elektrisch leitfähig gekoppelt, so dass zwischen dem elektronischen Chip 104 und der MEMS-Komponente 106 elektrische Signale propagieren können. In anderen Ausführungsbeispielen, in denen der elektronische Chip 104 in einer Flip Chip Konfiguration montiert ist, kann der Bonddraht 120 weggelassen werden und kann die elektrische Kopplung des Flip Chip montierten elektronischen Chips 104 mittels Lotkügelchen erfolgen.

Eine kappenartige Abdeckstruktur 108, die gemäß dem gezeigten Ausführungsbeispiel als Sektion oder Abschnitt einer weiteren gedruckten Leiterplatte (PCB) ausgebildet ist, ist auf der Basisstruktur 102 zum Abdecken der MEMS-Komponente 106 montiert. Dies bedeutet, dass auch die Abdeckstruktur 108 dielektrisches Material (insbesondere FR4) und eine elektrisch leitfähige Kontaktstruktur 110 aus Kupfer aufweisen kann, entsprechend der Basisstruktur 102. Die Abdeckstruktur 108 kann alternativ zum Beispiel auch als Metalldeckel oder Vergussmasse ausgebildet sein.

Im vorliegenden Fall ist der elektronische Chip 104 zum Steuern der MEMS-Komponente 106 konfiguriert. Dies bedeutet, dass der elektronische Chip 104 der als Lautsprecher ausgebildeten MEMS-Komponente 106 für einen zu reproduzieren Audioinhalt indikative elektrische Signale übermittelt, auf deren Basis eine schwingfähige Membran 160 der MEMS-Komponente 106 zu Schwingungen angeregt wird. Dadurch werden akustische Wellen erzeugt, die durch eines von Durchgangslöchern 112 in einem Außengehäuse des Packages 100 in die Umgebung ausgesandt werden.

Sowohl die Basisstruktur 102 als auch die Abdeckstruktur 108 weist ein jeweiliges Durchgangsloch 112 zum Bereitstellen einer Luftverbindung zwischen der MEMS-Komponente 106 und einer Umgebung des Package 100 auf, durch die eine Schallverbindung zwischen einem Inneren und einem Äußeren des Packages 100 ausgebildet wird. Ein äußerer Bereich des Durchgangslochs 112, das in der Basisstruktur 102 gebildet ist, ist mit einem Fasenabschnitt 154 versehen, um die akustischen Wellenpropagationseigenschaften zwischen einem Inneren und einem Äußeren des Packages 100 zu verbessern.

Die MEMS-Komponente 106 ist abstandsbehaftet in einer (zum Beispiel mittels Ätzens der PCB Struktur erzeugten) Kavität 114 bzw. einer Aussparung der Abdeckstruktur 108 angeordnet, die zwischen der Basisstruktur 102 und der Abdeckstruktur 108 begrenzt ist. Dadurch ist sichergestellt, dass die Membran 160 der MEMS-Komponente 106 frei schwingfähig ist.

Das Package 100 weist elektrisch leitfähiges Bondmaterial 116 (zum Beispiel metallisches Lotmaterial) an einer Montagestelle zwischen der Basisstruktur 102 und der Abdeckstruktur 108 auf. Da dieses elektrisch leitfähige Bondmaterial 116 beidseitig (d.h. oberseitig und unterseitig) die elektrisch leitfähigen Kontaktstrukturen 110 der Basisstruktur 102 und der Abdeckstruktur 108 berührt und miteinander verbindet, ist mittels des Bondmaterials 116 auch eine elektrisch leitfähige Verbindung zwischen der Basisstruktur 102 und der Abdeckstruktur 108 geschaffen.

In Figur 1 ist ein Package 100 zu erkennen, bei dem die MEMS-Komponente 106 als MEMS-Lautsprecher ausgebildet ist. Bei einer Ausgestaltung als MEMS-Lautsprecher stellt der elektronische Chip 104 über die elektrisch leitfähige Kontaktstruktur 110 Steuersignale an den Lautsprecher in Form der MEMS-Komponente 106 bereit, welche von einer piezoelektrischen Membran 160 der MEMS-Komponente 106 in Schall umgewandelt werden. Dieser Schall tritt durch eines der Durchgangslöcher 112 in eine Umgebung aus, wo dieser hörbar ist.

Eine ähnliche Konfiguration kann auch als MEMS-Mikrofon dienen. Bei einer Ausgestaltung als Mikrofon würden akustische Wellen aus der Umgebung durch eine oder beide der Durchgangslöcher 112 in die Kavität 114 propagieren und die piezoelektrische Membran 160 zu Schwingungen anregen. Dadurch würden an der MEMS-Komponente 106 entsprechende elektrische Signale erzeugt werden, die an den elektronischen Chip 104 übermittelt und dort weiterverarbeitet werden können.

Durch das Vergraben des elektronischen Chips 104 in der Basisstruktur 102 ist ein vertikales Anordnen von elektronischem Chip und MEMS-Struktur 106 ermöglicht, was zu einer kompakten Bauform in Höhenrichtung führt. Außerdem ist durch das Vorsehen von plattenförmigen PCBs als Basis für die Basisstruktur 102 und die Abdeckstruktur 108 ebenfalls eine geringe Bauhöhe erreicht. Indem der elektronische Chip 104 und die MEMS-Komponente 106 annähernd vertikal übereinander angeordnet sind, ist auch in lateraler Richtung eine kompakte Bauform ermöglicht.

An einer Unterseite des Package 100 gemäß Figur 1 ist dieses an einem Substrat montierbar, zum Beispiel an einer gedruckten Leiterplatte (nicht gezeigt).

**Figur 2** zeigt eine Querschnittsansicht eines Package 100 gemäß einem anderen exemplarischen Ausführungsbeispiel der Erfindung. Das Package 100 gemäß Figur 2 ist als Balanced-Armature-Empfänger (balanced armature receiver) konfiguriert.

Das Package 100 gemäß Figur 2 unterscheidet sich von dem Package 100 gemäß Figur 1 dadurch, dass gemäß Figur 2 die größere der beiden Durchgangsöffnungen 112 (ein sogenanntes Ventilierloch) seitlich, und nicht an einer Unterseite der Basisstruktur 102 angebracht ist. Dadurch ist eine Montage der Unterfläche des Packages 100 an einer nicht gezeigten Unterlage möglich, ohne dass die Luftverbindung der MEMS-Komponente 106 dadurch beeinträchtigt würde. Ein Ventilierluftkanal, der durch das untere Durchgangsloch 112 konstituiert wird, ist dadurch teilweise parallel zu der Membran 160 der MEMS-Komponente 106 ausgerichtet.

**Figur 3** zeigt eine Querschnittsansicht eines Package 100 gemäß einem anderen exemplarischen Ausführungsbeispiel der Erfindung. Das Package 100 gemäß Figur 3 ist als teilweise Balanced-Armature-Empfänger (partially balanced armature receiver) konfiguriert.

Das Package 100 gemäß Figur 3 unterscheidet sich von dem Package 100 gemäß Figur 1 bzw. Figur 2 dadurch, dass gemäß Figur 3 eine stufenförmige Unterseite vorgesehen ist. In einem Bereich der Stufe ist das untere Durchgangsloch 112 angeordnet, wohingegen ein anderer Bereich der Stufe zum Montieren des Packages 100 an einer Unterlage frei ist.

**Figur 4** zeigt eine Querschnittsansicht des Package 100, wie dieses mittels Bondmaterial 402 an einem Substrat 400 montiert ist. Das Substrat 400 ist im gezeigten Ausführungsbeispiel als gedruckte Leiterplatte (printed circuit board, PCB) ausgeführt und hat einen elektrisch isolierenden Kern (core) 404 und eine elektrisch leitfähigen Verdrahtung 406, mit der das Substrat 400 mit dem Package 100 elektrisch gekoppelt ist. Daher zeigt Figur 4 einen Empfänger auf einem PCB.

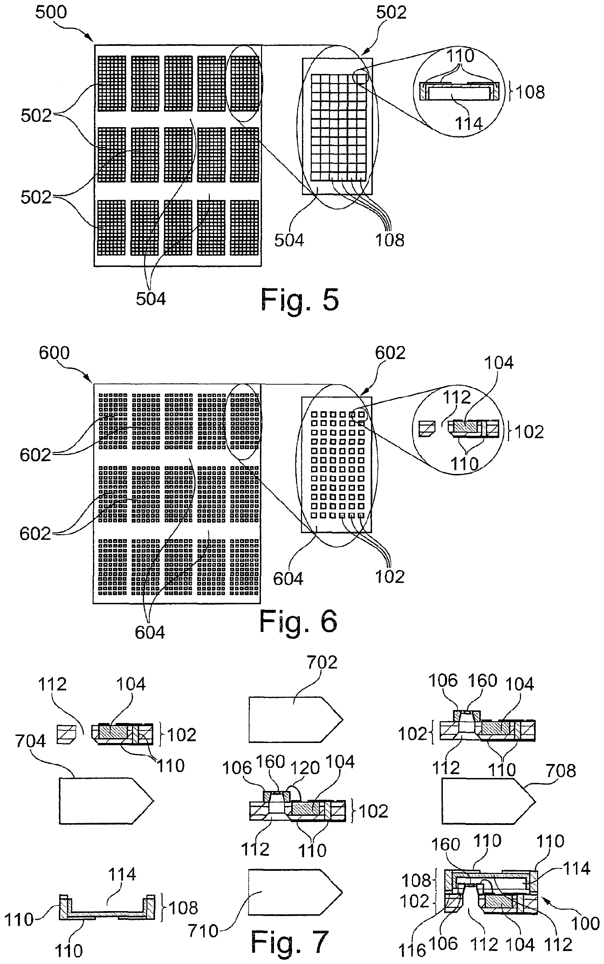

**Figur 5** zeigt eine Abdeckmasterstruktur 500 gemäß einem exemplarischen Ausführungsbeispiel der Erfindung.

Die Abdeckmasterstruktur 500 ist auf einer gedruckten Leiterplatte ausgebildet. Eine Mehrzahl von aktiven Abdeckbereichen 502 ist matrixförmig, das heißt in Zeilen und Spalten, auf der gezeigten Hauptoberfläche der Abdeckmasterstruktur 500 angeordnet. Zwischen den aktiven Abdeckbereichen 502 sind inaktive Bereiche 504 vorgesehen. Figur 5 zeigt ferner, dass jeder der aktiven Abdeckbereiche 502 wiederum eine Mehrzahl von in Zeilen und Spalten angeordnete Abdeckstrukturen 108 aufweist. Diese können ausgestaltet sein, wie bezugnehmend auf Figur 1 bis Figur 3 beschrieben. Die dafür vorgesehenen Kavitäten 114 können zum Beispiel mittels Ätzens erzeugt werden. Insgesamt zeigt Figur 5, dass die dortige Abdeckmasterstruktur 500 für eine batchweise Produktion von Packages 100 gemäß exemplarischen Ausführungsbeispielen sehr gut geeignet ist.

**Figur 6** zeigt eine Basismasterstruktur 600 gemäß einem exemplarischen Ausführungsbeispiel der Erfindung.

Bei der Basismasterstruktur 600 sind Packageausbildbereiche 602 in Zeilen und Spalten angeordnet sind und durch inaktive Bereiche 604 getrennt. Ferner ist in Figur 6 einer der Packageausbildbereiche 602 in einer vergrößerten Darstellung gezeigt, in der zu erkennen ist, dass in Zeilen und Spalten, mithin matrixförmig, eine Mehrzahl von Basisstrukturen 102 gebildet sind. Diese können ausgebildet sein, wie gemäß Figur 1 bis 3 gezeigt.

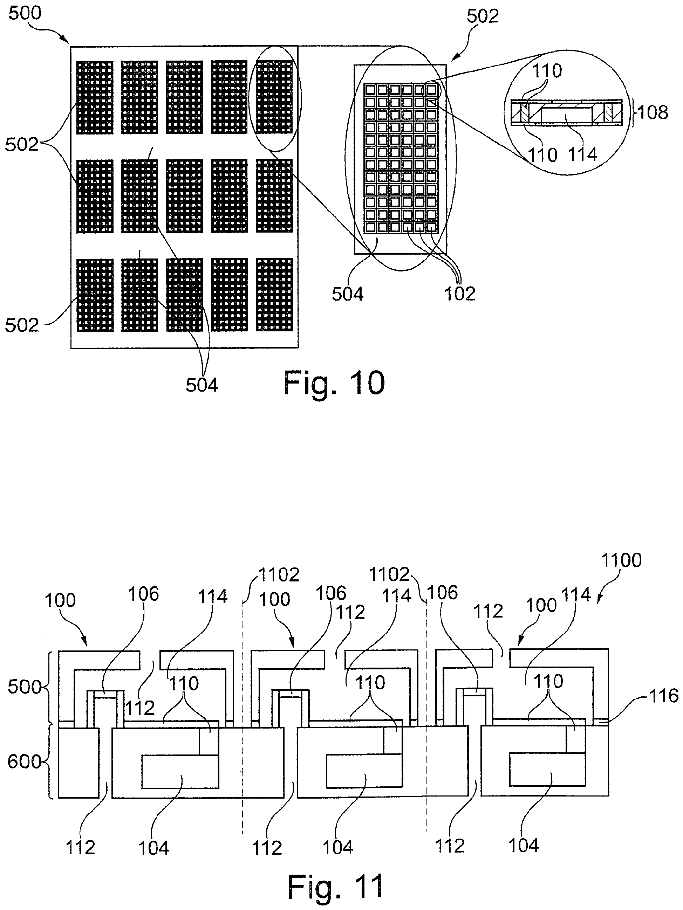

Um eine Mehrzahl von Packages 100 batchweise herzustellen, kann die Abdeckmasterstruktur 500 gemäß Figur 5 mittels nicht gezeigter Klebstoffmasse oder eines anderen Bondmaterials an der Basismasterstruktur 600 gemäß Figur 6 befestigt werden. Nachfolgend kann eine Singularisierung der so erhaltenen Anordnung (siehe Bezugszeichen 1100 in Figur 11) durchgeführt werden, um die einzelnen Packages 100 voneinander zu trennen.

**Figur 7** zeigt eine schematische Ansicht von Prozessen während eines Verfahrens zum Herstellen von Packages 100 gemäß einem exemplarischen Ausführungsbeispiel der Erfindung.

Wie mit Bezugszeichen 702 dargestellt, kann zunächst mittels Die-Bonding die MEMS-Komponente 106 an einer Oberseite der Basisstruktur 102 so befestigt werden, dass dadurch gleichzeitig eine mechanische Befestigung ermöglicht ist und eine elektrische Kontaktierung zu dem vergraben in der Basisstruktur 102 vorgesehenen elektronischen Chip 104 vorbereitet ist. Wie mit Bezugszeichen 704 gezeigt, kann mittels Wirebondens ein Bonddraht 120 an der MEMS-Komponente 106 angebracht werden, um diese mit dem elektronischen Chip 104 elektrisch zu koppeln. Wie mit Bezugszeichen 708 gezeigt, kann eine Kavität 114 in den Abdeckstrukturen 108 gebildet werden. Nachfolgend kann eine batchweise Verbindung zwischen einer Basismasterstruktur 600 und einer Abdeckmasterstruktur 500 oder eine Verbindung zwischen einer bereits singularisierten Basisstruktur 102 und einer bereits singularisierten Abdeckstruktur 108 vorgenommen werden, um das in Figur 7 gezeigte Package 100 zu erzeugen. Bei einer batchweisen Prozessierung erfolgt nachfolgend eine Singularisierung in einzelne Packages 100.

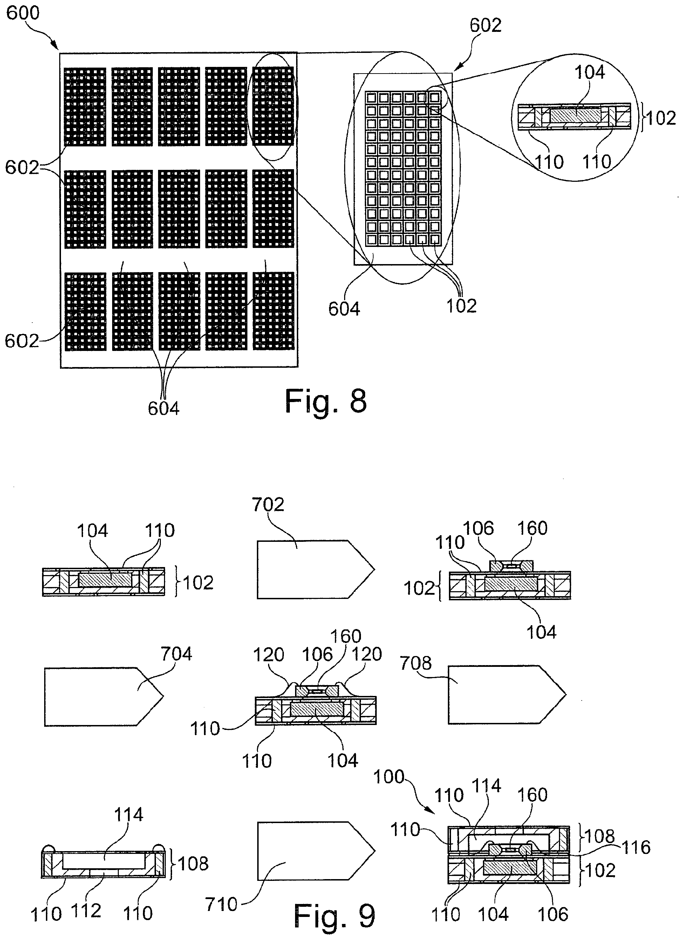

**Figur 8, Figur 9** und **Figur 10** zeigen eine sehr ähnliche Prozedur wie Figur 5 bis Figur 7, wobei Figur 8 Figur 6 entspricht, Figur 9 Figur 7 entspricht und Figur 10 Figur 5 entspricht. Der Unterschied zwischen dem Ausführungsbeispiel von Figur 8 bis Figur 10 verglichen mit dem Ausführungsbeispiel von Figur 5 bis Figur 7 ist, dass unterschiedliche Basisstrukturen 102 und unterschiedliche Abdeckstrukturen 108 implementiert sind. Gemäß Figur 8 bis Figur 10 ist die jeweilige MEMS-Komponente 106 direkt über dem elektronischen Chip 104 angeordnet, anstatt seitlich verschoben angeordnet zu sein, wie gemäß Figur 5 bis Figur 7.

**Figur 11** zeigt eine Querschnittsansicht einer Anordnung 1100 gemäß einem exemplarischen Ausführungsbeispiel der Erfindung.

Die Anordnung 1100 weist Basismasterstruktur 600, eine Mehrzahl von elektronischen Chips 104, die in der Basismasterstruktur 600 eingebettet sind, eine Mehrzahl von MEMS-Komponenten 106 auf der Basismasterstruktur 600 und Abdeckmasterstruktur 500 auf, die an bzw. auf der Basismasterstruktur 600 montiert ist und die MEMS-Komponenten 106 abdeckt. Dadurch sind individuelle Kavitäten 114 für jede der MEMS-Komponenten 106 zwischen einem jeweiligen Abschnitt der Basismasterstruktur 600 und einem jeweiligen Abschnitt der Abdeckmasterstruktur 500 definiert.

In der in Figur 11 gezeigten Anordnung 1100 kann ein Vereinzeln in Packages 100 erfolgen, indem entlang von Trenn- oder Schnittlinien 1102 (zum Beispiel mittels Sägens, Laserschneidens oder Ätzens) die einzelnen Packages 100 voneinander getrennt werden.

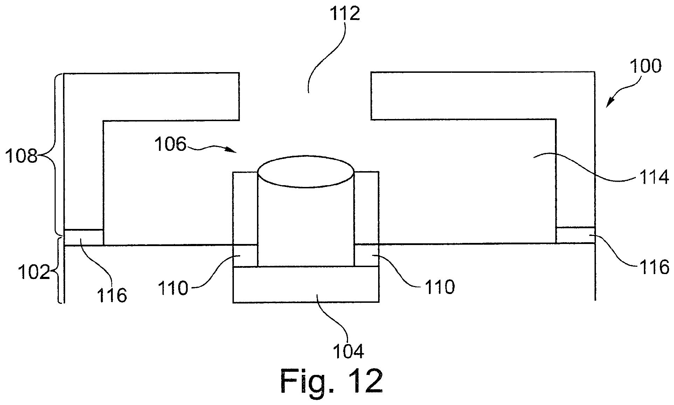

**Figur 12** zeigt eine Querschnittsansicht eines Package 100 gemäß einem anderen exemplarischen Ausführungsbeispiel der Erfindung.

Gemäß Figur 12 ist der elektronische Chip 104 als CCD (charge coupled device) ausgebildet und detektiert elektromagnetische Strahlung. Der elektronische Chip 104 des CCD Typs ist in der Basisstruktur 102 eingebettet, wobei eine obere Fläche des CCD Chips gegenüber der Basisstruktur 102 freigelegt ist, um für elektromagnetische Strahlung empfänglich zu sein. Der elektronische Chip 104 wirkt mittels der elektrisch leitfähigen Kontaktstruktur 110 mit einer elektrisch bewegbaren Linse zusammen, die als MEMS-Komponente 106 oberhalb des elektronischen Chips 104 angeordnet ist, um als anpassbares optisches Element zum Beeinflussen der mittels der CCD detektierten elektromagnetischen Strahlung zu dienen. In dem Ausführungsbeispiel gemäß Figur 12 ist zumindest ein Abschnitt der Abdeckstruktur 108 oberhalb der MEMS-Komponente 106 und des elektronischen Chips 104 optisch transparent oder sollte die Abdeckstruktur 108 ein Durchgangsloch 112 haben, das es Licht erlaubt, in die Kavität 114 zu propagieren.

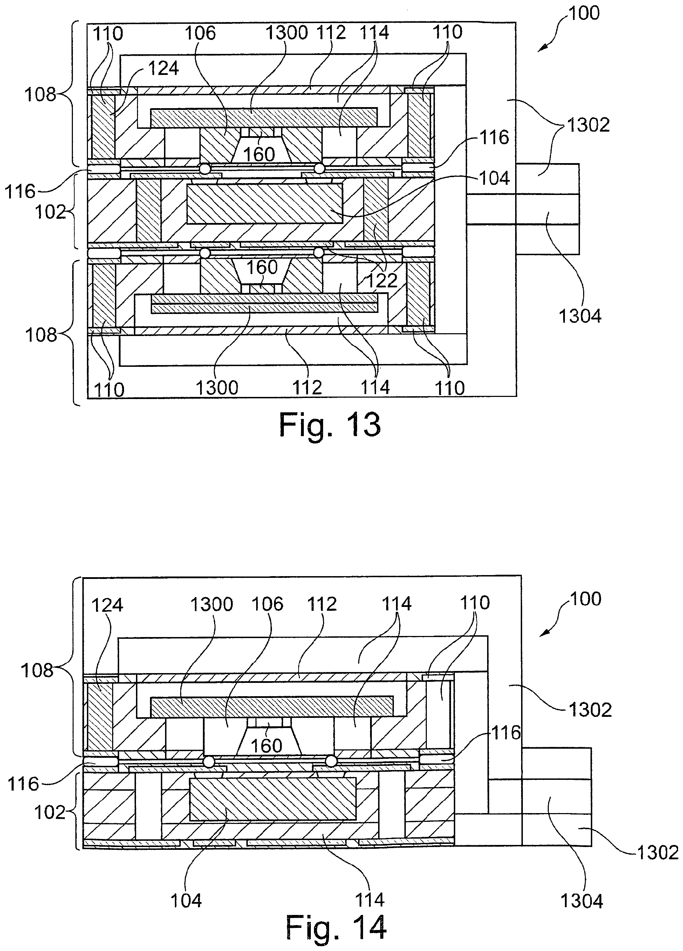

**Figur 13** und **Figur 14** zeigen Querschnittsansichten von Packages 100 gemäß anderen exemplarischen Ausführungsbeispielen der Erfindung.

Das in Figur 13 gezeigte Package 100 ist als Balanced Armature Receiver (BAR) mit einer beidseitigen Konfiguration ausgebildet. Dies bedeutet, dass eine Basisstruktur 102 mit eingebetteter elektronischer Komponente 104 auf jeder von ihren beiden gegenüberliegenden Hauptflächen mit einer jeweiligen MEMS-Komponente 106 bestückt ist, die wiederum mittels einer jeweiligen Abdeckstruktur 108 abgedeckt ist. Zusätzlich bedeckt eine Membran 1300 eine freiliegende Oberfläche der jeweiligen MEMS-Komponente 106. Die Membran 1300 kann zum Beispiel aus Silikon oder einem anderen Polymermaterial hergestellt werden. Daher kann eine kompakte Gestaltung mit einem hohen Level von Funktionalität kombiniert werden. Figur 13 zeigt darüber hinaus ein Gehäuse 1302 (zum Beispiel aus Metall oder aus Kunststoff), das als Schallwellenleiter dient und eine Schallzugangsöffnung 1304 aufweist.

Das in Figur 14 gezeigte Package 100 ist als Balanced Armature Receiver (BAR) mit einer einseitigen Konfiguration ausgebildet. Dies bedeutet, dass eine Basisstruktur 102 mit eingebetteter elektronischer Komponente 104 nur auf einer von ihren beiden gegenüberliegenden Hauptflächen mit einer MEMS-Komponente 106 bestückt ist, die wiederum mittels einer Membran 1300 bedeckt ist und von einer Abdeckstruktur 108 umgeben ist. Auch gemäß Figur 14 ist ein Gehäuse 1302 vorgesehen, das entsprechend Figur 13 konfiguriert ist.

Ergänzend ist darauf hinzuweisen, dass "aufweisend" keine anderen Elemente oder Schritte ausschließt und "eine" oder "ein" keine Vielzahl ausschließt. Ferner sei darauf hingewiesen, dass Merkmale oder Schritte, die mit Verweis auf eines der obigen Ausführungsbeispiele beschrieben worden sind, auch in Kombination mit anderen Merkmalen oder Schritten anderer oben beschriebener Ausführungsbeispiele verwendet werden können. Bezugszeichen in den Ansprüchen sind nicht als Einschränkung anzusehen.

## Patentansprüche

1. Package, aufweisend:
eine Basisstruktur (102), die ein elektrisch isolierendes Material und/oder eine elektrisch leitfähige Kontaktstruktur (110) aufweist;
einen elektronischen Baustein (104), der in der Basisstruktur (102) eingebettet ist;
eine mikroelektromechanische System- (microelectromechanical system, MEMS) Komponente (106); und
eine Abdeckstruktur (108), die auf der Basisstruktur (102) zum zumindest teilweisen Abdecken der MEMS-Komponente (106) montiert ist,
wobei die Abdeckstruktur (108) eine gedruckte Leiterplatte oder eine Sektion davon ist,
wobei die Basisstruktur (102) und die Abdeckstruktur (108) direkt miteinander verbunden sind mittels zumindest einem aus der Gruppe, welche besteht aus Löten, mechanischem Zusammenpressen, Verwenden von Bondmaterial, und
wobei jede der Basisstruktur (102) und der Abdeckstruktur (108) zumindest ein Durchgangsloch (112) zum Bereitstellen einer Fluidverbindung zwischen der MEMS-Komponente (106) und einer Umgebung des Package (100) aufweist.

2. Package (100) gemäß Anspruch 1, wobei die Basisstruktur (102) als Leiterplatte konfiguriert ist, insbesondere als gedruckte Leiterplatte, oder als Sektion davon.

3. Package (100) gemäß einem der Ansprüche 1 oder 2, wobei das elektrisch isolierende Material aus einer Gruppe ausgewählt ist, die besteht aus Harz, insbesondere Bismaleimid-Triazin Harz, Glasfasern, Prepreg-Material, Polyimid, ein Flüssigkristall-Polymer, Epoxid-basierten Build-Up Film und FR4 Material.

4. Package (100) gemäß einem der Ansprüche 1 bis 3, wobei das Package zumindest eines der folgenden Merkmale aufweist:
der elektronische Baustein (104) ist konfiguriert zum funktionellen Zusammenwirken mit, insbesondere zum Steuern von, der MEMS-Komponente (106) ;
die MEMS-Komponente (106) ist ausgebildet als eine aus der Gruppe bestehend aus einem Sensor, einem Aktuator, einem Lautsprecher, einem Balanced Armature Empfänger, einem Mikrofon, einer Autofokuskomponente, einem insbesondere zweidimensionalen Scanner, einem haptischen Aktuator, einem Drucksensor, einer Mikropumpe, einer einstellbaren Linse, einem einstellbaren wellenlängenselektiven Filter, und einem Fluidsensor;
der elektronische Baustein (104) ist ein Halbleiterchip, insbesondere ein anwendungsspezifischer integrierter Schaltkreischip (ASIC, application specific integrated circuit);
zumindest ein Teil von seitlichen Oberflächen des elektronischen Bausteins (104) ist mit Material der Basisstruktur (102) bedeckt.

5. Package (100) gemäß einem der Ansprüche 1 bis 4, wobei zumindest eine aus der Gruppe bestehend aus der Basisstruktur (102) und der Abdeckstruktur (108) eine Akustikwellenbeeinflussungs-Oberflächenstrukturierung aufweist, insbesondere gefast ist.

6. Package (100) gemäß einem der Ansprüche 1 bis 5, wobei die MEMS-Komponente (106) in einer Kavität (114) angeordnet ist, die zwischen der Basisstruktur (102) und der Abdeckstruktur (108) begrenzt ist.

7. Package (100) gemäß einem der Ansprüche 1 bis 6, wobei die Abdeckstruktur (108) zumindest eines aus der Gruppe aufweist, die besteht aus einer EMI Schutzeinrichtung, eine ESD Schutzeinrichtung, mindestens einem Lötpad, und einem Akustikeigenschaftsanpassmerkmal, insbesondere einer Funktionalisierung oder einer Strukturierung zum passiven Filtern von akustischen Wellen.

8. Package (100) gemäß einem der Ansprüche 1 bis 7, aufweisend Bondmaterial (116) an einer Montagestelle zwischen der Basisstruktur (102) und der Abdeckstruktur (108), insbesondere wobei das Bondmaterial (116) zum Bereitstellen von sowohl einer mechanischen Verbindung als auch einer elektrischen Kopplung zwischen der Basisstruktur (102) und der Abdeckstruktur (108) konfiguriert ist.

9. Package (100) gemäß einem der Ansprüche 1 bis 8, wobei zumindest ein Teil der elektrisch leitfähigen Kontaktstruktur (110) zum elektrischen Koppeln des elektronischen Bausteins (104) mit der MEMS-Komponente (106) konfiguriert ist.

10. Package (100) gemäß einem der Ansprüche 1 bis 9, wobei die MEMS-Komponente (106) auf der Basisstruktur (102) und/oder auf der Abdeckstruktur (108) montiert ist.

11. Verfahren zum Herstellen von Packages (100), wobei das Verfahren aufweist:
Einbetten eines elektronischen Bausteins (104) in einer Basisstruktur (102), die ein elektrisch isolierendes Material und/oder eine elektrisch leitfähige Kontaktstruktur (110) aufweist;
Montieren einer mikroelektromechanischen System-(microelectromechanical, MEMS) Komponente (106), insbesondere an der Basisstruktur (102); und
zumindest teilweises Abdecken der MEMS-Komponente (106) mit einer Abdeckstruktur (108), die an der Basisstruktur (102) montiert ist,
wobei die Abdeckstruktur (108) eine gedruckte Leiterplatte oder eine Sektion davon ist,
wobei die Basisstruktur (102) und die Abdeckstruktur (108) direkt miteinander verbunden sind mittels zumindest einem aus der Gruppe, welche besteht aus Löten, mechanischem Zusammenpressen, Verwenden von Bondmaterial, und
wobei jede der Basisstruktur (102) und der Abdeckstruktur (108) zumindest ein Durchgangsloch (112) zum Bereitstellen einer Fluidverbindung zwischen der MEMS-Komponente (106) und einer Umgebung des Package (100) aufweist.

12. Verfahren gemäß Anspruch 11, wobei das Verfahren ferner aufweist:
Einbetten von zumindest einem weiteren elektronischen Baustein (104) in oder Anordnen des zumindest einen weiteren elektronischen Bausteins (104) auf einer Basismasterstruktur (600), wobei die Basisstruktur (102) Teil der Basismasterstruktur (600) bildet;
Montieren von zumindest einer weiteren MEMS-Komponente (106), insbesondere an der Basismasterstruktur (600);
zumindest teilweises Abdecken der zumindest einen weiteren MEMS-Komponente (106) mit einer Abdeckmasterstruktur (500), die an der Basismasterstruktur (600) montiert wird, wobei die Abdeckstruktur (108) Teil der Abdeckmasterstruktur (500) bildet.

13. Verfahren gemäß Anspruch 12, wobei das Verfahren ferner ein Singularisieren der Anordnung der Basismasterstruktur (600) mit den elektronischen Bausteinen (104) und den montierten MEMS-Komponenten (106) und der Abdeckmasterstruktur (500) aufweist, um dadurch eine Mehrzahl von Packages (100) zu erhalten, von denen jede Basisstruktur (102), elektronischen Baustein (104), MEMS-Komponente (106) und Abdeckstruktur (108) aufweist.

14. Verfahren gemäß Anspruch 12 oder 13, wobei die elektronischen Bausteine (104) und die MEMS-Komponenten (106) zweidimensional über die Basismasterstruktur (600) und die Abdeckmasterstruktur (500) hinweg verteilt sind.

15. Eine Anordnung (1100), wobei die Anordnung (1100) aufweist:
eine Basismasterstruktur (600), die elektrisch isolierendes Material und/oder eine elektrisch leitfähige Kontaktstruktur (110) aufweist;
eine Mehrzahl von elektronischen Bausteinen (104), die in der Basismasterstruktur (600) eingebettet sind;
eine Mehrzahl von MEMS-Komponenten (106), insbesondere an der Basismasterstruktur (600);
eine Abdeckmasterstruktur (500), die an der Basismasterstruktur (600) montiert ist und die MEMS-Komponenten (106) zumindest teilweise abdeckt, um so individuelle Kavitäten (114) für jede der MEMS-Komponenten (106) zwischen einem jeweiligen Abschnitt der Basismasterstruktur (600) und einem jeweiligen Abschnitt der Abdeckmasterstruktur (500) zu definieren,
wobei die Abdeckmasterstruktur (500) eine gedruckte Leiterplatte oder eine Sektion davon ist,
wobei die Basismasterstruktur (600) und die Abdeckmasterstruktur (500) direkt miteinander verbunden sind mittels zumindest einem aus der Gruppe, welche besteht aus Löten, mechanischem Zusammenpressen, Verwenden von Bondmaterial, und
wobei jede der Basismasterstruktur (600) und der Abdeckmasterstruktur (500) zumindest ein Durchgangsloch (112) zum Bereitstellen einer Fluidverbindung zwischen der MEMS-Komponente (106) und einer Umgebung der Anordnung (1100) aufweist.

## Claims

1. A package, comprising:
a base structure (102) comprising an electrically insulating material and/or an electrically conductive contact structure (110);
an electronic component (104) embedded in the base structure (102);
a micro electronic system (microelectromechanical system, MEMS) component (106); and
a cover structure (108), which is mounted on the base structure (102) for at least partially covering the MEMS-component (106),
wherein the cover structure (108) is a printed circuit board or a section thereof,
wherein the base structure (102) and the cover structure (108) are connected directly by means of at least one of the group which consists of soldering, mechanical compression, using bonding material, and
wherein each of the base structure (102) and the cover structure (108) comprises at least one through hole (112) for providing a fluid connection between the MEMS-component (106) and an environment of the package (100).

2. The package (100) according to claim 1, wherein the base structure (102) is configured as a circuit board, in particular as a printed circuit board, or as a section thereof.

3. The package (100) according to one of the claims 1 or 2, wherein the electrically insulating material is selected from a group consisting of resin, in particular bismaleimide-triazine resin, glass fibers, prepreg-material, polyimide, a liquid crystal polymer, epoxy-based build up-film and FR4 material.

4. The package (100) according to one of the claims 1 to 3, wherein the package comprises at least one of the following features:
the electronic component (104) is configured for functionally cooperating with, in particular for controlling, the MEMS-component (106);
the MEMS-component (106) is formed as one of the group consisting of a sensor, an actuator, a loudspeaker, a balanced armature receiver, a microphone, an auto focus component, a particular two-dimensional scanner, a haptic actuator, a pressure sensor, a micro pump, an adjustable lens, an adjustable wavelength-selective filter, and a fluid sensor;
the electronic component (104) is a semiconductor chip, in particular an application specific integrated circuit (ASIC);
at least a part of the surfaces at a side of the electronic component (104) is covered with material of the base structure (102).

5. The package (100) according to one of the claims 1 to 4, wherein at least one of the group consisting of the base structure (102) and the cover structure (108) comprises a surface structuring for influencing acoustic wave, in particular is chamfered.

6. The package (100) according to one of the claims 1 to 5, wherein the MEMS-component (106) is arranged in a cavity (114), which is confined between the base structure (102) and the cover structure (108).

7. The package (100) according to one of the claims 1 to 6, wherein the cover structure (108) comprises at least one of the group consisting of an EMI protection device, an ESD protection device, at least one solder pad, and an acoustic property matching feature, in particular a functionalization or a structuring for passively filtering of acoustic waves.

8. The package (100) according to one of the claims 1 to 7, comprising bonding material (116) at a mounting site between the base structure (102) and the cover structure (108) in particular wherein the bonding material (116) is configured for providing both a mechanical connection and an electric coupling between the base structure and the cover structure (108).

9. The package (100) according to one of the claims 1 to 8, wherein at least a portion of the electrically conductive contact structure (110) is configured for electrically coupling the electronic component (104) with the MEMS component (106).

10. The package (100) according to one of the claims 1 to 9, wherein the MEMS component (106) is mounted on the base structure (102) and/or on the cover structure (108).

11. A method for manufacturing packages (100), the method comprising:
embedding an electronic component (104) in a base structure (102), which comprises an electrically insulating material and/or an electrically conductive contact structure (110);
mounting a microelectromechanical system (MEMS) component (106), in particular at the base structure (102); and
at least partially covering the MEMS component (106) with a cover structure (108), which is mounted at the base structure (102),
wherein the cover structure (108) is a printed circuit board or a section thereof,
wherein the base structure (102) and the cover structure (108) are connected directly by means of at least one of the group consisting of soldering, mechanical compression, using bonding material, and
wherein each of the base structure (102) and the cover structure (108) comprise at least one through hole (112) for providing a fluid connection between the MEMS-component (106) and an environment of the package (100).

12. Method according to claim 11, the method further comprising:
embedding at least one further electronic component (104) in, or arranging the at least one further electronic component (104) on, a base master structure (600), wherein the base structure (102) forms a portion of the base master structure (600);
mounting at least one further MEMS component (106), in particular at the base master structure (600);
at least partially covering the at least one further MEMS component (106) with a cover master structure (500), which is mounted at the base master structure (600), wherein the cover structure (108) forms a portion of the cover master structure (500).

13. Method according to claim 12, wherein the method further comprises singularizing the arrangement of the base master structure (600) having the electronic components (104) and the mounted MEMS components (106) and the cover master structure (500), in order to thereby obtain a plurality of packages (100), each of which comprises a base structure (102), an electronic component (104), a MEMS component (106) and a cover structure (108).

14. The method according to claims 12 or 13, wherein the electronic components (104) and the MEMS components (106) are distributed two-dimensionally across the base master structure (600) and the cover master structure (500).

15. An assembly (1100), wherein the assembly (1100) comprises:
a base master structure (600), which has an electrically insulating material and/or an electrically conductive contact structure (110);
a plurality of electronic components (104), which are embedded in the base master structure (600);
a plurality of MEMS components (106), in particular at the base master structure (600);
a cover master structure (500), which is mounted at the base master structure (600) and at least partially covers the MEMS components (106), in order to thus define individual cavities (114) for each one of the MEMS components (106) between a respective section of the base master structure (600) and a respective section of the cover master structure (500),
wherein the cover master structure (500) is a printed circuit board or a section thereof,
wherein the base master structure (600) and the cover master structure (500) are connected directly by means of at least one of the group consisting of soldering, mechanical compression, using bonding material, and
wherein each of the base master structure (600) and the cover master structure (500) comprise at least one through hole (112) for providing a fluid connection between the MEMS-component (106) and an environment of the assembly (1100).

## Revendications

1. Boîtier comprenant :
une structure de base (102) comprenant un matériau électriquement isolant et/ou une structure de contact (110) électriquement conductrice ;
un dispositif électronique (104) intégré dans la structure de base (102) ;
un composant (106) de système micro-électromécanique (microelectromechanical system, MEMS) ; et
une structure de recouvrement (108) montée sur la structure de base (102) pour recouvrir au moins partiellement le composant MEMS (106),
la structure de recouvrement (108) étant une carte à circuit imprimé ou une portion de celle-ci,
la structure de base (102) et la structure de recouvrement (108) étant directement liées l'une à l'autre par au moins un membre du groupe constitué par la soudure, la compression mécanique, et l'utilisation d'un matériau de liaison, et
chacune parmi la structure de base (102) et la structure de recouvrement (108) ayant au moins un trou traversant (112) pour fournir une communication fluidique entre le composant MEMS (106) et un environnement du boîtier (100).

2. Boîtier (100) selon la revendication 1, dans lequel la structure de base (102) est configurée sous la forme d'une carte à circuit, en particulier sous la forme d'une carte à circuit imprimé, ou sous la forme d'une portion de celle-ci.

3. Boîtier (100) selon l'une quelconque des revendications 1 ou 2, dans lequel le matériau électriquement isolant est choisi dans un groupe constitué par une résine, en particulier une résine bismaléimide-triazine, des fibres de verre, un matériau pré-imprégné, un polyimide, un polymère à cristaux liquides, un film de montage à base d'époxy et un matériau FR4.

4. Boîtier (100) selon l'une quelconque des revendications 1 à 3, dans lequel le boîtier comprend au moins l'une des caractéristiques suivantes :
le dispositif électronique (104) est configuré pour interagir fonctionnellement avec, en particulier commander, le composant MEMS (106) ;
le composant MEMS (106) est conçu sous la forme d'un membre du groupe constitué par un capteur, un actionneur, un haut-parleur, un récepteur à armature équilibrée, un microphone, un composant autofocus, un scanner, en particulier un scanner bidimensionnel, un actionneur haptique, un capteur de pression, une micropompe, une lentille réglable, un filtre sélectif à longueur d'onde réglable et un capteur de fluide ;
le dispositif électronique (104) est une puce semi-conductrice, en particulier une puce de circuit intégré spécifique à une application (ASIC, application specific integrated circuit) ;
au moins une partie des surfaces latérales du dispositif électronique (104) est recouverte d'un matériau de la structure de base (102).

5. Boîtier (100) selon l'une quelconque des revendications 1 à 4, dans lequel au moins un membre du groupe constitué par la structure de base (102) et la structure de recouvrement (108) présente une structuration de surface influençant les ondes acoustiques, en particulier est biseauté.

6. Boîtier (100) selon l'une quelconque des revendications 1 à 5, dans lequel le composant MEMS (106) est disposé dans une cavité (114) délimitée entre la structure de base (102) et la structure de recouvrement (108).

7. Boîtier (100) selon l'une quelconque des revendications 1 à 6, dans lequel la structure de recouvrement (108) comprend au moins un membre du groupe constitué par un dispositif de protection contre les interférences électromagnétiques, un dispositif de protection contre les décharges électrostatiques, au moins une pastille de soudure, et une caractéristique d'adaptation aux propriétés acoustiques, notamment une fonctionnalisation ou une structuration pour filtrer passivement les ondes acoustiques.

8. Boîtier (100) selon l'une quelconque des revendications 1 à 7, comprenant un matériau de liaison (116) à un emplacement de montage entre la structure de base (102) et la structure de recouvrement (108), en particulier dans lequel le matériau de liaison (116) est configuré pour fournir à la fois une connexion mécanique et une liaison électrique entre la structure de base (102) et la structure de recouvrement (108).

9. Boîtier (100) selon l'une quelconque des revendications 1 à 8, dans lequel au moins une partie de la structure de contact (110) électriquement conductrice est configurée pour relier électriquement le dispositif électronique (104) au composant MEMS (106).

10. Boîtier (100) selon l'une quelconque des revendications 1 à 9, dans lequel le composant MEMS (106) est monté sur la structure de base (102) et/ou sur la structure de recouvrement (108).

11. Procédé de fabrication de boîtiers (100), le procédé comprenant :
le fait d'incorporer un composant électronique (104) dans une structure de base (102) comprenant un matériau électriquement isolant et/ou une structure de contact (110) électriquement conductrice ;
le fait de monter un composant (106) de système micro-électromécanique (microelectromechanical, MEMS), en particulier sur la structure de base (102) ; et
le fait de recouvrir au moins partiellement le composant MEMS (106) avec une structure de recouvrement (108) montée sur la structure de base (102),
la structure de recouvrement (108) étant une carte à circuit imprimé ou une portion de celle-ci,
la structure de base (102) et la structure de recouvrement (108) étant directement connectées l'une à l'autre au moyen d'au moins un membre du groupe constitué par la soudure, la compression mécanique et l'utilisation d'un matériau de liaison, et
chacune parmi la structure de base (102) et la structure de recouvrement (108) ayant au moins un trou traversant (112) pour fournir une communication fluidique entre le composant MEMS (106) et un environnement du boîtier (100).

12. Procédé selon la revendication 11, le procédé comprenant en outre :
le fait d'incorporer au moins un autre composant électronique (104) dans ou d'agencer ledit au moins un autre composant électronique (104) sur une structure maîtresse de base (600), la structure de base (102) faisant partie de la structure maîtresse de base (600) ;
le fait de monter au moins un autre composant MEMS (106), en particulier sur la structure maîtresse de base (600) ;
le fait de recouvrir au moins partiellement ledit au moins un autre composant MEMS (106) avec une structure maîtresse de recouvrement (500) montée sur ladite structure maîtresse de base (600), ladite structure de recouvrement (108) faisant partie de ladite structure maîtresse de recouvrement (500).

13. Procédé selon la revendication 12, dans lequel le procédé comprend en outre la singularisation de l'agencement de la structure maîtresse de base (600) avec les dispositifs électroniques (104) et les composants MEMS montés (106) et la structure maîtresse de recouvrement (500) pour obtenir ainsi une pluralité de boîtiers (100) comprenant chacun une structure de base (102), un dispositif électronique (104), un composant MEMS (106) et une structure de recouvrement (108).

14. Procédé selon la revendication 12 ou la revendication 13, dans lequel les dispositifs électroniques (104) et les composants MEMS (106) sont répartis de manière bidimensionnelle sur la structure maîtresse de base (600) et la structure maîtresse de recouvrement (500).

15. Un ensemble (1100), l'ensemble (1100) comprenant :
une structure maîtresse de base (600) comprenant un matériau électriquement isolant et/ou une structure de contact (110) électriquement conductrice ;
une pluralité de composants électroniques (104) intégrés dans la structure maîtresse de base (600) ;
une pluralité de composants MEMS (106), en particulier sur la structure maîtresse de base (600) ;
une structure maîtresse de recouvrement (500) montée sur la structure maîtresse de base (600) et recouvrant au moins partiellement les composants MEMS (106) de manière à définir des cavités individuelles (114) pour chacun des composants MEMS (106) entre une partie respective de la structure maîtresse de base (600) et une partie respective de la structure maîtresse de recouvrement (500),
la structure maîtresse de recouvrement (500) est une carte à circuit imprimé ou une portion de celle-ci,
la structure maîtresse de base (600) et la structure maîtresse de recouvrement (500) étant directement liées ensemble par au moins un membre du groupe constitué par la soudure, la compression mécanique, l'utilisation d'un matériau de liaison, et
chacune parmi la structure maîtresse de base (600) et de la structure maîtresse de recouvrement (500) ayant au moins un trou traversant (112) pour fournir une communication fluidique entre le composant MEMS (106) et un environnement du dispositif (1100).
